(19) Europäisches Patentamt
European Patent Office
Office européen des brevets

(11) **EP 4 439 991 A1**

(12) **DEMANDE DE BREVET EUROPEEN**

(43) Date de publication:
**02.10.2024 Bulletin 2024/40**

(21) Numéro de dépôt: **24166470.5**

(22) Date de dépôt: **26.03.2024**

(51) Classification Internationale des Brevets (IPC):
**H04B 3/46** (2015.01)  **G01R 31/11** (2006.01)
**H04L 43/00** (2022.01)

(52) Classification Coopérative des Brevets (CPC):
**H04B 3/46; G01R 31/11**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **29.03.2023 FR 2303037**

(71) Demandeur: **COMMISSARIAT À L'ÉNERGIE ATOMIQUE ET AUX ÉNERGIES ALTERNATIVES**
**75015 Paris (FR)**

(72) Inventeurs:
• **SCHELLEKENS, Vincent**
**91191 GIF-SUR-YVETTE CEDEX (FR)**
• **BENOIT, Jaume**
**91191 GIF-SUR-YVETTE CEDEX (FR)**
• **JACQUES, Marie-Bénédicte**
**91191 GIF-SUR-YVETTE CEDEX (FR)**

(74) Mandataire: **Atout PI Laplace**
**Immeuble Up On**
**25 Boulevard Romain Rolland**
**CS 40072**
**75685 Paris Cedex 14 (FR)**

(54) **PROCÉDÉ ITÉRATIF DE RECONSTRUCTION DE LA TOPOLOGIE D'UN RÉSEAU DE CÂBLES**

(57) Procédé itératif de reconstruction de la topologie d'un réseau de câbles, comprenant les étapes de :
- Obtenir (200) un réflectogramme temporel mesuré,
- Rechercher un modèle de topologie de réseau de câbles correspondant audit réflectogramme mesuré en exécutant à partir d'un modèle initial de topologie, plusieurs itérations d'au moins deux étapes successives de transformation d'un modèle de topologie :
i. Une première étape d'optimisation (202) des branches non optimisées d'au moins un modèle de topologie sauvegardé à l'itération précédente, l'optimisation portant au moins sur la longueur des branches et/ou l'impédance des charges en fin de branches,
ii. Une seconde étape de génération (204) de nouveaux modèles de topologie en remplaçant une charge en fin de branche d'un modèle de topologie sauvegardé après la première étape d'optimisation (202), par une jonction vers plusieurs branches non optimisées.

FIG.1

**Description**

L'invention concerne le domaine de l'analyse technique et la surveillance de réseaux de câbles complexes. Plus précisément, elle porte sur un procédé de reconstruction de la topologie d'un réseau de câbles. L'invention vise à proposer une méthode permettant de déterminer la topologie d'un réseau, c'est-à-dire les points de jonctions entre plusieurs câbles, le nombre de câbles connectés en chaque point ainsi que leurs longueurs respectives mais également les impédances des charges en fin de câble. La méthode proposée est basée sur l'exploitation d'un réflectogramme temporel obtenu par une injection d'un signal maîtrisé dans le réseau de câbles puis par une mesure du signal réfléchi sur les différentes discontinuités d'impédance du réseau. Ainsi, l'invention concerne plus largement le domaine des méthodes dites de réflectométrie qui visent à fournir des informations sur un câble ou un réseau de câbles à partir d'un réflectogramme.

Les câbles sont omniprésents dans tous les systèmes électriques, pour l'alimentation ou la transmission d'information à l'intérieur de bâtiments ou de véhicules tels que des aéronefs. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du réseau à tester. Le signal se propage dans le câble ou le réseau et renvoie une partie de son énergie lorsqu'il rencontre une discontinuité électrique. Une discontinuité électrique peut résulter, par exemple, d'une jonction ou d'une charge en fin de câble ou plus généralement d'une rupture des conditions de propagation du signal dans le câble.

L'analyse des signaux renvoyés au point d'injection permet d'en déduire des informations sur la présence et la localisation de ces discontinuités correspondant aux points caractéristiques de la topologie du réseau. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention s'applique à tout type de réseaux de câbles, notamment des câbles électriques, en particulier des câbles de transmission d'énergie ou des câbles de communication, dans des installations fixes ou mobiles. Les câbles concernés peuvent être coaxiaux, bifilaires, en lignes parallèles, en paires torsadées ou autre, pourvu qu'il soit possible d'y injecter un signal de réflectométrie en un point du réseau de câble et de mesurer sa réflexion au même point ou en un autre point.

La présente invention a notamment pour objectif de permettre la reconstruction de la topologie de réseaux de câbles complexes dont les plans ne sont pas disponibles où pour lesquels une intervention urgente nécessite la connaissance immédiate de la topologie du réseau. Ce type de problème existe notamment pour des réseaux de câbles électriques ou d'énergie à l'intérieur d'un bâtiment ou à l'intérieur d'un véhicule. Un technicien souhaitant effectuer un dépannage du réseau suite à la détection d'un problème électrique peut avoir besoin d'une connaissance précise de la topologie du réseau pour l'aider dans l'élaboration de son diagnostic. Par ailleurs, certains bâtiments présentent un niveau de confidentialité qui interdit, par nature, la diffusion des plans du réseau électrique.

L'état de l'art comporte différentes solutions qui visent à déterminer une topologie d'un réseau de câbles à partir d'une mesure de réflectométrie.

La demande de brevet WO2019/030246 du Demandeur décrit un premier type de méthode de reconstruction de topologie d'un réseau de câbles à partir d'une mesure de réflectométrie. Cette méthode est basée sur une optimisation via un algorithme génétique. Un inconvénient de cette approche est que son comportement est très aléatoire et peut ne pas converger ou converger très lentement pour certaines topologies de réseaux de câbles particulières. Par ailleurs le résultat est non déterministe, c'est-à-dire qu'il ne génère pas toujours la même solution à partir du même réflectogramme.

La demande de brevet WO2019/034497 du Demandeur décrit un autre type de méthode basée sur un algorithme itératif glouton. Cette seconde approche est sensible aux optima locaux et donc présente un risque non négligeable de convergence vers des solutions incorrectes.

Il existe donc un besoin pour résoudre les inconvénients des méthodes de l'art antérieur afin d'améliorer la fiabilité ou la robustesse des méthodes basées sur des algorithmes gloutons et améliorer la vitesse de convergence des méthodes basées sur des algorithmes génétiques.

La méthode proposée vise à construire progressivement un ensemble de modèles de réseaux de câbles « candidats » en conservant en mémoire certaines solutions afin de les améliorer de sorte à éviter une convergence vers des optima locaux qui ne correspondent pas à la solution réelle.

L'invention permet d'assurer un compromis le plus optimal possible entre vitesse de convergence et robustesse.

La méthode proposée est basée sur l'exécution itérative de différentes fonctions qui visent à faire évoluer un modèle de réseau initial en optimisant les valeurs des longueurs des branches et des impédances de charges en fin de branches et en ajoutant des jonctions de façon progressive.

Un avantage procuré par l'invention réside dans la possibilité de réaliser plusieurs itérations de la méthode en élargissant le périmètre des solutions à explorer parmi celles conservées en mémoire aux itérations précédentes.

Ainsi, l'invention permet une convergence rapide pour les structures de réseaux simples à détecter et laisse la possibilité d'une convergence plus lente pour les structures plus complexes. Dans tous les cas, la méthode est déterministe et présente un niveau de fiabilité plus élevé que les méthodes de l'art antérieur précitées en ce qu'elle permet de reconstruire correctement la topologie de n'importe quel réseau dans une très grande majorité de cas.

L'invention a pour objet un procédé itératif, mis en oeuvre par ordinateur, de reconstruction de la topologie d'un réseau de câbles, le procédé comprenant les étapes de :

- Obtenir un réflectogramme temporel mesuré à partir d'un signal préalablement injecté dans le réseau de câbles,

- Rechercher un modèle de topologie de réseau de câbles correspondant audit réflectogramme mesuré en exécutant à partir d'un modèle initial de topologie, plusieurs itérations d'au moins deux étapes successives de transformation d'un modèle de topologie :

    i. Une première étape d'optimisation des branches non optimisées d'au moins un modèle de topologie sauvegardé à l'itération précédente, l'optimisation portant au moins sur la longueur des branches et/ou l'impédance des charges en fin de branches,

    ii. Une seconde étape de génération de nouveaux modèles de topologie en remplaçant une charge en fin de branche d'un modèle de topologie sauvegardé après la première étape d'optimisation, par une jonction vers plusieurs branches non optimisées,

- Chaque étape de transformation impliquant le calcul d'une fonction de cout représentative d'une erreur entre le réflectogramme temporel mesuré et un réflectogramme simulé à partir d'un modèle de topologie,

- A l'issue de chaque étape de transformation, sauvegarder les modèles de topologie pour lesquels le rapport entre la fonction de cout calculée pour le modèle obtenu après transformation et celle calculée pour le modèle avant transformation, appelée valeur d'amélioration relative, est inférieure à une valeur maximale d'un seuil prédéterminé.

Selon un aspect particulier de l'invention, chacune des deux étapes de transformation comprend la sélection, parmi les modèles sauvegardés, de ceux pour lesquels la valeur d'amélioration relative est inférieure à une valeur courante du seuil prédéterminé.

Selon un aspect particulier de l'invention, la première étape d'optimisation comprend, pour chaque branche d'un modèle de topologie à optimiser, le calcul de plusieurs valeurs d'amélioration relative pour différentes hypothèses de longueur de branche et/ou différentes hypothèses de valeurs d'impédance de charges.

Selon un aspect particulier de l'invention, la seconde étape de génération de nouveaux modèles de topologie comprend, pour chaque nouveau modèle de topologie optimisé par la première étape d'optimisation, le calcul de plusieurs valeurs d'amélioration relative pour différentes valeurs de nombre de branches non optimisées connectées à une jonction modélisée en remplacement d'une charge en fin de branche optimisée.

Selon un aspect particulier de l'invention, le seuil prédéterminé a une valeur différente pour chacune des deux étapes de transformation.

Selon un aspect particulier de l'invention, la valeur du seuil prédéterminé pour la première étape d'optimisation est inférieure à 1, par exemple comprise entre 0.5 et 0.99.

Selon un aspect particulier de l'invention, la valeur du seuil prédéterminé pour la seconde étape de génération est supérieure à 1, par exemple comprise entre 1.01 et 1.2.

Dans une variante de réalisation, le procédé selon l'invention comprend, lorsque le nombre de branches n d'un modèle de topologie généré par la seconde étape de génération atteint une valeur maximale prédéfinie N, une nouvelle itération de l'ensemble des étapes du procédé en augmentant la valeur courante du seuil prédéterminé pour au moins l'une des étapes de transformation.

Dans une variante de réalisation, le procédé selon l'invention comprend en outre une étape supplémentaire d'optimisation des modèles de topologie optimisés par la première étape d'optimisation en recherchant, pour chaque paramètre à optimiser, sur un intervalle prédéfini centré sur la valeur dudit paramètre, une valeur modifiée qui minimise la fonction de cout sur l'intervalle.

Dans une variante de réalisation, le procédé selon l'invention comprend en outre une troisième étape de transformation d'un modèle de topologie consistant à ajouter à une branche d'un modèle de topologie sauvegardé à l'étape précédente une nouvelle jonction en une position variable et, pour chaque nouveau modèle de topologie optimisé lors des étapes précédentes, le calcul de plusieurs valeurs d'amélioration relative pour différentes valeurs de ladite position.

Dans une variante de réalisation, le procédé selon l'invention comprend une étape d'arrêt du procédé lorsque la fonction de cout calculée pour au moins un modèle de topologie est inférieure à un seuil d'arrêt prédéterminé.

Dans une variante de réalisation, le procédé selon l'invention comprend une étape d'affichage de la topologie reconstruite du réseau de câbles sur un dispositif d'affichage.

Dans une variante de réalisation, le procédé selon l'invention comprend une étape préalable d'injection du signal dans le réseau de câbles.

L'invention a aussi pour objet un programme d'ordinateur comportant des instructions pour l'exécution du procédé de reconstruction de la topologie d'un réseau de câbles selon l'invention, lorsque le programme est exécuté par un processeur.

L'invention a aussi pour objet un support d'enregistrement lisible par un processeur sur lequel est enregistré un programme comportant des instructions pour l'exécution du procédé de reconstruction de la topologie d'un réseau de câbles selon l'invention, lorsque le programme est exécuté par un processeur.

D'autres caractéristiques et avantages de la présente invention apparaîtront mieux à la lecture de la description qui suit en relation aux dessins annexés suivants.

[Fig. 1] représente un schéma illustrant le problème général visé par l'invention,

[Fig. 2] représente un organigramme détaillant les étapes de mise en oeuvre d'une méthode de reconstruction de topologie selon un mode de réalisation de l'invention,

[Fig. 3] représente un tableau dans lequel sont mémorisées un ensemble de solutions intermédiaires obtenues au cours des itérations de la méthode selon l'invention,

[Fig. 4a] représente un exemple de réflectogramme temporel mesuré,

[Fig. 4b] représente un exemple de zone de recherche de paramètres à optimiser,

[Fig. 5] représente un organigramme détaillant un exemple de mise en oeuvre d'une étape d'optimisation de la méthode selon l'invention,

[Fig. 6] représente un organigramme détaillant un exemple de mise en oeuvre d'une étape de génération de nouveaux modèles de topologie de la méthode selon l'invention,

[Fig. 7a] représente un exemple de topologie de réseau correctement reconstruite par l'invention,

[Fig. 7b] représente, pour le même exemple, un résultat obtenu via une approche itérative de l'art antérieur,

[Fig. 8] représente un exemple de système apte à exécuter l'invention.

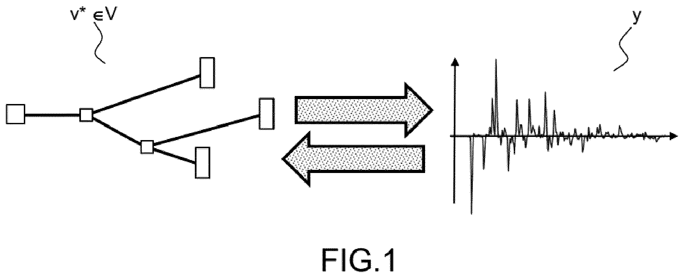

La figure 1 schématise le problème général visé par l'invention. Ce problème consiste à déterminer la topologie d'un réseau de câbles inconnu v* e V à partir d'une mesure d'un réflectogramme y obtenue pour ce réseau.

La topologie d'un réseau de câbles est définie notamment par son nombre de branches, la longueur de chaque branche, la valeur de l'impédance des charges à l'extrémité de chaque branche, les jonctions entre différentes branches. Sans sortir du cadre de l'invention, d'autres paramètres peuvent être pris en compte comme les caractéristiques physiques spécifiques à chaque câble.

Le problème général à résoudre peut être vu comme un problème d'optimisation qui consiste à rechercher la

solution $\hat{v} = \min_{v \in V} C(v)$ qui permet de minimiser une fonction de cout C qui est caractéristique d'une erreur ou d'une distance entre le réflectogramme mesuré y et un réflectogramme simulé S(v) à partir d'un modèle de topologie de réseau v.

Par exemple, la fonction de cout C est définie par une distance entre les deux réflectogrammes $C(v) = \| S(v) - y \|_2$.

Comme cela est connu par ailleurs, une mesure de réflectométrie est obtenue en injectant un signal maîtrisé en un point du réseau de câbles puis en mesurant, au même point ou en un point différent du réseau, le signal qui est rétro-propagé après avoir subi de multiples réflexions sur les discontinuités d'impédance apparaissant dans les câbles du réseau. La mesure de réflectométrie peut être obtenue au moyen d'un dispositif de mesure comprenant un générateur de signal, un convertisseur numérique analogique, un coupleur pour injecter le signal analogique dans le câble et mesurer sa réflexion, un convertisseur analogique numérique, un processeur et une mémoire pour calculer le réflectogramme et le sauvegarder. Le signal utilisé peut être de nature diverse, il peut s'agir d'un simple signal Gaussien, d'un créneau temporel ou d'une impulsion ou bien d'un signal plus complexe. En fonction de la nature exacte du signal, le réflectogramme temporel est obtenu directement par la mesure du signal rétro-propagé ou bien par un calcul d'inter-corrélation entre cette mesure et une copie du signal injecté dans le réseau. De façon générale, toute mesure de signal comprenant l'information relative aux réflexions du signal sur les points singuliers du réseau, c'est-à-dire les jonctions et les charges en fin de câbles, est compatible de l'invention. Il convient de noter que la mesure du réflectogramme temporel ne nécessite l'accès qu'à un seul port de test du réseau.

Pour simuler un réflectogramme temporel à partir de la définition d'une topologie de réseau de câbles, il est aussi connu, de modéliser la propagation du signal sur les discontinuités d'impédance correspondants aux points singuliers du réseau, par exemple en se basant sur les équations du télégraphiste qui permettent de décrire l'évolution de la tension et du courant sur une ligne électrique en fonction de la distance et du temps.

$$\frac{\partial v(x,t)}{\partial x} = -Ri(x,t) - L\frac{\partial i(x,t)}{\partial t} \qquad (1)$$

$$\frac{\partial i(x,t)}{\partial x} = -Gv(x,t) - C\frac{\partial v(x,t)}{\partial t} \qquad (2)$$

Les paramètres R,L,C,G correspondent respectivement à la résistance, à l'inductance, à la capacitance et à la conductance de la ligne.

L'invention vise ainsi à proposer une nouvelle méthode d'optimisation permettant de trouver de façon itérative la solution optimale v qui minimise la fonction de cout C(v).

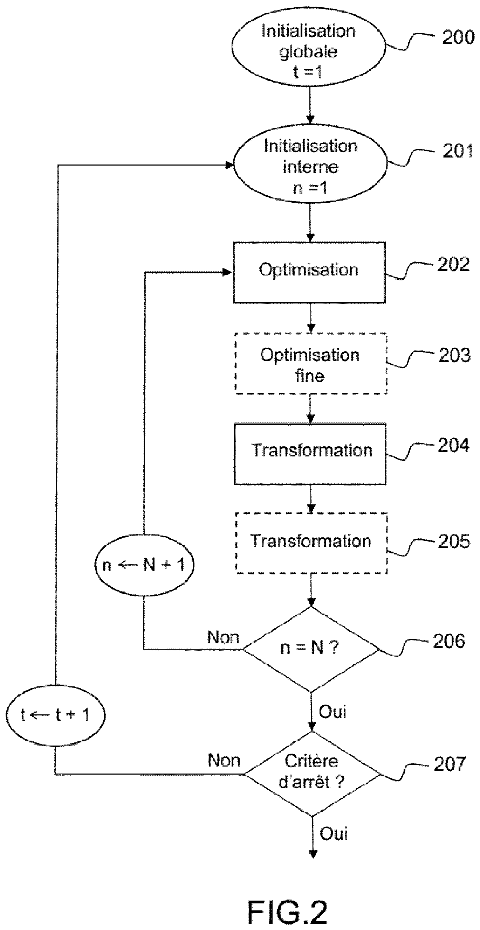

La figure 2 décrit, sur un organigramme, les étapes de mise en oeuvre de l'invention sur un exemple de réalisation.

La méthode proposée est itérative et fonctionne, tel qu'indiqué sur la figure 2, selon deux boucles d'itérations respectivement sur les variables t et n.

La variable n correspond au nombre de branches d'un modèle de topologie de réseau, n varie de 1 à N, où N est le nombre maximal de branches qu'on s'autorise pour la recherche du modèle de topologie optimal correspondant à un réflectogramme mesuré.

La variable t correspond à un niveau de contrainte relatif à l'espace des solutions sauvegardées en mémoire et que l'on s'autorise à explorer à nouveau à l'itération courante. La variable t varie de 1 à T où T correspond à un niveau de contrainte le plus faible pour lequel on s'autorise à explorer toutes les solutions sauvegardées en mémoire. Les niveaux t inférieurs à T correspondent à des niveaux de contraintes plus élevés pour lesquels l'espace des solutions explorées est réduit.

Un avantage au fonctionnement itératif sur la variable t est qu'il permet une convergence rapide lorsque la topologie recherchée est simple tout en gardant une convergence robuste (bien que plus lente) lorsque la topologie recherchée est complexe.

Autrement dit, la variable t contrôle l'évolution dynamique d'un critère d'explorabilité des solutions. Il évolue de t=1 correspondant à un critère très exigeant pour lequel seules les solutions les plus prometteuses sont considérées, au niveau maximum t=T correspondant au critère le moins exigeant pour lequel toutes les solutions sauvegardées sont considérées.

Considérer une solution signifie partir de cette solution pour l'optimiser ou la modifier afin de générer une ou plusieurs nouvelles autres solutions.

Typiquement, l'itération t=t+1 est atteinte lorsqu'au stade t, aucune solution satisfaisante n'a été trouvée et on s'autorise une recherche parmi des solutions moins prometteuses. L'itération t=T est atteinte lorsqu'à ce stade on s'autorise une recherche parmi toutes les solutions les moins prometteuses restantes.

La méthode débute à l'étape 200 avec l'initialisation de la variable t à 1, ce qui correspond au niveau de contrainte le plus élevé.

L'étape 200 d'initialisation comporte l'acquisition d'une mesure d'un réflectogramme obtenu sur un réseau de câbles dont la topologie est inconnue et que l'on souhaite retrouver. Elle comporte également la définition d'un modèle initial de topologie de réseau à partir duquel la recherche d'optimisation va débuter, ce modèle est, par exemple, un modèle simple constitué d'une seule branche non optimisée.

A l'étape 201, pour chaque nouvelle itération sur la variable t, on initialise la variable n à 1 ce qui correspond à un modèle de topologie à une seule branche. Ceci comprend au départ un modèle initial de topologie à une seule branche non optimisée.

L'étape 201 comporte également la fixation de seuils d'explorations qui dépendent de l'itération t comme cela sera décrit plus en détail par la suite.

Les seuils d'exploration sont des seuils d'acceptation de solutions produites par transformation. On fixe également un nombre de solutions maximal à considérer dépendant de l'itération t.

Une branche non optimisée est une branche dont on ne connaît pas la longueur ni l'impédance de charge en fin de branche.

Une branche non optimisée peut être modélisée par une branche adaptée, c'est-à-dire, un câble terminé par une charge d'impédance égale à l'impédance caractéristique du câble, ce qui correspond à une absence de réflexion du signal et donc de pic correspondant sur le réflectogramme simulé.

A chaque itération sur la variable n, on exécute plusieurs étapes 202,203,204,205 de transformation du modèle de topologie initial pour produire une ou plusieurs nouvelles solutions de modèles qui peuvent correspondre à la topologie recherchée. La variable n définit le nombre de branches des modèles explorés à l'itération courante.

A l'étape 206, lorsque le nombre maximal de branches N est atteint, on passe à l'étape 207 lors de laquelle un critère d'arrêt de l'algorithme est exécuté pour vérifier si l'un des modèles générés a une fonction de cout inférieure à un seuil donné, auquel cas ce modèle est retenu comme la solution finale. Dans le cas contraire, on passe à une nouvelle itération sur la variable t en relâchant les contraintes d'exploration des solutions sauvegardées.

On décrit à présent plus en détail chacune des étapes de transformation d'un modèle de topologie.

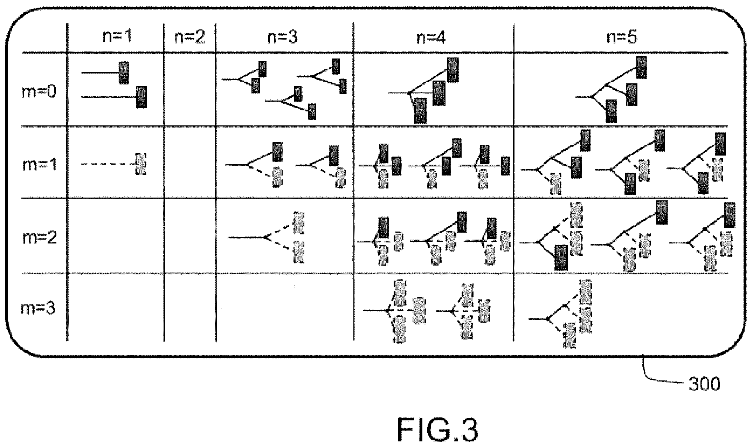

Pour cela, on s'appuie sur une représentation des solutions de modèles de topologie sauvegardées sous la forme d'un tableau 300 représenté à la figure 3.

Les solutions obtenues après chaque étape de transformation sont sauvegardées dans les cases du tableau 300 selon le nombre de branches n total du modèle (correspondant aux colonnes du tableau) et au nombre de branches non optimisées m du modèle (correspondant aux lignes du tableau).

Dans l'exemple de la figure 3, n varie de 1 à 5 et m varie de 0 à 3.

La méthode débute avec un modèle de topologie initial simple, par exemple un modèle à une seule branche non optimisée représentée dans la case (n=1 ,m=1) du tableau 300.

Sur la figure 3, les différents exemples de topologie de réseau sont donnés à titre purement illustratif afin d'expliciter sur un exemple le fonctionnement de l'invention.

Les branches non optimisées sont représentées en pointillés tandis que les branches déjà optimisées sont représentées en traits pleins.

L'étape 202 est une étape d'optimisation qui a pour but d'optimiser des branches non optimisées des modèles de topologie générés aux itérations précédentes et sauvegardées dans la colonne d'indice n du tableau 300.

Plus précisément, l'étape 202 vise à rechercher des minima locaux, pour la fonction de cout, en faisant varier les paramètres de longueur de branche et de valeur d'impédance de charge en fin de branche.

Les plages de recherche des paramètres sont définies en fonction de la nature du réflectogramme mesuré.

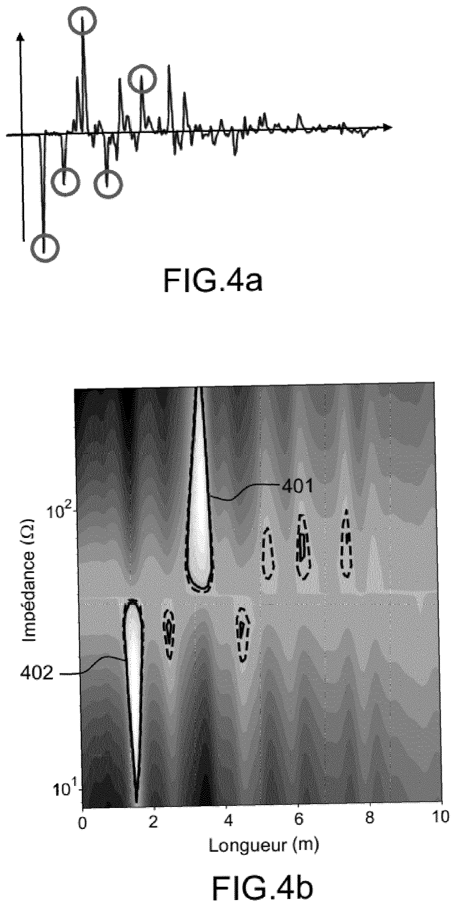

A titre d'exemple, la figure 4a représente un réflectogramme temporel mesuré sur lequel sont identifiés plusieurs pics d'amplitudes qui correspondent potentiellement à des charges ou à des jonctions du réseau.

La figure 4b montre une grille de recherche des paramètres respectifs de longueur d'une branche (en abscisse) et d'impédance de charge en fin de branche (en ordonnée). Les valeurs recherchées sont préférentiellement concentrées dans des zones correspondant aux pics du réflectogramme.

Pour une itération courante sur l'indice n, on se place dans la colonne d'indice n correspondante du tableau 300 et l'optimisation débute en partant de la valeur de m la plus élevée pour laquelle au moins un modèle de topologie a été généré antérieurement.

Par exemple, initialement pour n=1, on part de la case (m=1,n=1) dans laquelle est sauvegardée un modèle constitué d'une seule branche non optimisée.

Aux itérations sur n supérieures, par exemple à n=4, on part de la case (m=3,n=4) dans laquelle sont sauvegardées plusieurs modèles constitués de plusieurs branches non optimisées qui ont été obtenus à une itération précédente.

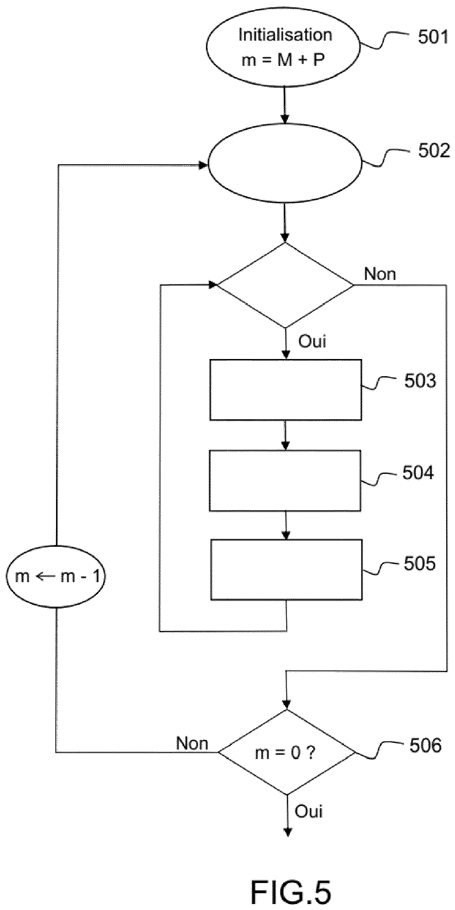

La figure 5 schématise un exemple de mise en oeuvre d'un algorithme d'optimisation exécuté à l'étape 202 de la méthode de la figure 2.

A l'étape 501, l'algorithme est initialisé en fixant la valeur de m (indice d'une ligne du tableau 300) à m =M+P.

M est le nombre de branches non optimisées maximal acceptées lors de l'étape de transformation 204. Dans un mode de réalisation préféré, M est pris égal à 0 mais de façon générale il peut être choisi supérieur ou égal à 1 afin d'explorer l'espace des solutions de façon plus complète.

P est le nombre maximal de branches non optimisées ajoutées lors de l'étape de transformation 204.

M + P est donc égal au nombre maximal de branches non optimisées qu'une solution peut avoir après l'opération 204. Ainsi, m correspond à l'indice de la dernière ligne possible dans la représentation en tableau des solutions 300.

A l'étape 502, on récupère, dans la case d'indice (m,n) du tableau 300, les solutions explorables à l'itération d'indice t. Il s'agit de toutes les solutions qui satisfont un critère d'explorabilité.

Un critère d'explorabilité est défini à chaque itération pour que chaque étape de l'algorithme explore certaines solutions précédemment trouvées, mais pas toutes, afin de limiter la complexité calculatoire.

Le critère d'explorabilité détermine si une solution v peut être explorée par une opération. Un exemple de critère consiste à satisfaire les trois conditions suivantes.

Tout d'abord, la solution v retenue n'a pas encore été explorée par l'opération en question à une itération précédente.

Ensuite, la solution v est prometteuse, au sens où sa valeur d'amélioration relative I(v) ne dépasse pas un seuil d'acceptation défini en fonction de l'itération t.

La valeur d'amélioration relative dépend de la solution précédente v' et d'une fonction de cout C.

Elle est donnée par exemple par la relation $I(v) = \frac{C(v)}{C(v')}$.

La fonction de cout C est par exemple égale à une distance entre le réflectogramme mesuré et un réflectogramme simulé à partir du modèle de topologie v.

Une solution v est retenue pour exploration si sa valeur d'amélioration relative est supérieure à un seuil d'acceptation qui dépend de l'opération et de l'itération t.

Pour l'opération d'optimisation 202, le seuil d'acceptation $\theta_t^O$ est préférentiellement choisi inférieur à 1 et par exemple compris entre 0.5 et 0.99.

Par ailleurs, sa valeur est croissante en fonction des itérations sur t. Par exemple $\theta_1^O = 0.8$ et $\theta_T^O = 0.98$ et la valeur du seuil croit entre ces deux bornes en fonction de la valeur de l'itération t.

La valeur du seuil d'acceptation pour l'opération d'optimisation est inférieure à 1 car on s'attend à pouvoir obtenir une réduction significative de la fonction de cout du fait de l'introduction d'un nouveau pic dans le réflectogramme simulé.

L'étape 502 détermine donc une liste L de solutions à explorer dans la case (n,m) du tableau 300, ces solutions ayant toutes une valeur d'amélioration relative qui est strictement inférieur au seuil d'acceptation $\theta_t^O$. Selon l'itération t, le seuil choisi sera plus ou moins élevé ce qui entraine un changement dans les contraintes et donc un espace de recherche de solutions à explorer plus ou moins important. Au maximum, le nombre de solutions retenues dans la liste L à l'étape 502 est égal au nombre de solutions en mémoire dans la case (n,m) du tableau 300.

Ce paramètre de l'invention permet ainsi d'obtenir le meilleur compromis entre vitesse d'exécution et de convergence (aux premières itérations sur t) et robustesse du fait de l'exploration de solutions dans un espace plus large (aux dernières itérations sur t).

Si le nombre de solutions de la liste L n'est pas nul, on passe à l'étape 503 pour parcourir la liste des solutions et fournir la prochaine solution v à traiter.

A l'étape 504, on recherche les branches non optimisées du modèle de topologie de la solution v.

On désigne par $\beta_1, ... , \beta_m$ la (ou les, si m > 1) branche(s) adaptée(s) du réseau v.

Si plusieurs branches adaptées partent de la même jonction, typiquement, pour un réseau sur lequel on vient d'appliquer une opération d'ajout de plusieurs branches, on ne garde qu'une seule de ces branches adaptées à la sortie de l'étape 504. Chacune des branches $\beta_i$ part donc d'une jonction différente.

Notons qu'on aura le plus souvent (i.e., lorsque M = 0) qu'une seule branche adaptée $\beta_1$, car dans ce cas les seules branches adaptées proviennent nécessairement d'une opération d'ajout de branches et elles se situent donc toutes à la même jonction. Cependant, si on a fixé M > 0, il est possible d'avoir des solutions avec des branches non optimisées partant de plusieurs jonctions (m > 1).

A l'étape 505, on procède ensuite à l'optimisation de la branche $\beta_i$ fournit en entrée. Cette optimisation consiste à déterminer au moins un paramètre parmi la longueur de la branche ainsi que la valeur de l'impédance de la charge à l'extrémité de la branche.

Lors de cette opération 505, on peut retenir plusieurs solutions en nombre maximal égal à J. Toutes les nouvelles solutions obtenues sont ajoutées à la case (n,m-1) du tableau 300. En effet, lorsqu'on optimise une branche, le nombre de branches non optimisées m est décrémenté.

L'opération d'optimisation 505 consiste par exemple en la réalisation d'une ou plusieurs des sous étapes suivantes.

On calcule la fonction de cout C(v) pour un ensemble de valeurs de longueur l de branche et de valeurs Z d'impédances de charges en fin de branche sur une grille telle que définie par exemple à la figure 4b.

Plus spécifiquement, la grille de recherche peut être définie comme suit :

- Pour les longueurs de branches, on considère toutes les longueurs entre $l = L_{min}$ et $l = L_{max}$ (une longueur de câble maximale que l'utilisateur doit définir), par incréments linéaires d'un paramètre $L_{coarse}$. Par exemple, $L_{min} = 0$.

- Pour les impédances de charges, au lieu de faire varier la valeur linéairement dans le domaine « naturel » de l'impédance $Z$, une possibilité est de la faire varier linéairement dans le domaine des coefficients de réflexion associés, ce qui est plus adéquat compte tenu du sens physique des mesures de réflectométrie. Plus précisément, on considère tous les coefficients de réflexion $\Gamma$ entre -1 et +1 par incréments linéaires de $\Gamma_{coarse}$ puis on en déduit la valeur de l'impédance $Z$ associée via la relation $$Z = Z(\Gamma) = Z_0 \frac{1+\Gamma}{1-\Gamma}$$ (où $Z_0$ désigne l'impédance caractéristique du câble).

- Pour chaque valeur de longueur de câble $l$ et coefficient de réflexion $\Gamma$ de la charge en bout de ligne ainsi obtenue, on simule le réflectogramme associé, qu'on compare au réflectogramme de référence pour obtenir la valeur de la fonction de coût, notée ici $C(l, \Gamma)$ ou $C(l, Z)$.

Une fois la fonction de coût connue sur la grille, il faut en déduire les minima locaux, ce qui est fait en suivant la procédure suivante.

On se restreint uniquement aux positions sur la grille $(L, \Gamma)$ dont le coût calculé $C(L, Z)$ satisfait $$C(L, Z) \leq \theta_T^o \times C(v')$$, où $C(v')$ désigne donc le coût du réseau avant le début de l'étape d'optimisation (où la branche qu'on considère n'est pas optimisée donc modélisée comme une branche adaptée). $\theta_T^o$ est le seuil d'acceptation maximal au delà duquel on considère que les solutions sont trop éloignées du modèle recherché et il n'est pas utile de les sauvegarder.

On organise ces positions en un graphe où chaque position $(L, \Gamma)$ est connectée aux voisins sur la grille : $(L - L_{coarse}, \Gamma)$, $(L + L_{coarse}, \Gamma)$, $(L, \Gamma - \Gamma_{coarse})$, et $(L, \Gamma + \Gamma_{coarse})$ (seulement si ces solutions ont aussi été sélectionnées pour leur coût prometteur).

On détermine ensuite quelles sont les composantes connexes dans ce graphe, c'est-à-dire, les voisinages de solutions sélectionnées connectées entre elles. Par exemple, sur l'illustration en figure 4b, chaque composante connexe est entourée d'un trait solide 401,402. On obtient une composante connexe par optimum local de la fonction cout, donc $J$ composantes connexes en tout.

Pour chaque composante connexe 401,402, on recherche son minimum localement. Autrement dit, parmi toutes les positions dans la composante connexe 401,402, on choisit la position $(L, Z)$ dont le coût est le plus bas, en utilisant le calcul de la fonction de coût $C(L,Z))$ et on en déduit une nouvelle solution. On obtient au total $J$ nouvelles solutions, une par minimum local.

Chaque nouvelle solution est ajoutée en suivant une procédure d'enregistrement des nouveaux réseaux qui consiste à enregistrer en plus du modèle de topologie obtenu, la valeur de la fonction de cout et la valeur d'amélioration relative et à vérifier si cette solution n'existe pas déjà dans le tableau 300.

De façon générale, l'étape 505 permet d'obtenir plusieurs nouvelles solutions optimisées à partir de chaque modèle précédemment sauvegardé qui comporte au moins une branche non optimisée.

En revenant à l'exemple de la figure 3, on peut voir qu'à partir de la solution initiale stockée en (m=1,n=1), deux solutions optimisées sont déterminées pour la case (m=0,n=1) qui correspondent à deux solutions différentes d'un réseau à une seule branche et une charge.

Le même principe est illustré pour les autres colonnes du tableau 300.

La valeur de m la plus élevée pour chaque colonne correspond au nombre de branches non encore optimisées et qui sont progressivement optimisées en décrémentant la valeur de m et remontant les cases du tableau.

Par exemple, pour (m=2,n=3), on a un réseau à 3 branches dont 2 branches non optimisées.

L'étape d'optimisation 505 permet de générer deux nouvelles solutions en (m=1 ,n=3) de réseaux à 3 branches dont chacun n'a plus qu'une seule branche non optimisée.

Enfin, trois solutions (en m=0,n=3) sont obtenues pour des réseaux à trois branches dont deux branches se terminant par une charge ayant une valeur optimisée.

Le même principe est appliqué pour les réseaux à 4 branches (n=4) et 5 branches (n=5) sur l'exemple de la figure 3.

Les étapes 503,504,505 sont itérées sur toute la liste L puis lorsque cette liste est vide, on décrémente l'indice m de 1 puis on retourne à l'étape 502 jusqu'à ce que la valeur de m soit nulle (étape 506).

A l'issue de l'étape d'optimisation 202, les cases du tableau 300 sont remplies, pour la colonne d'indice n en cours, avec une ou plusieurs solutions de topologies de réseaux de câbles.

Une étape optionnelle 203 peut être appliquée ensuite pour affiner les résultats d'optimisation obtenus à l'étape précédente. Cette étape ne produit pas de nouvelles topologies de réseaux mais peut modifier les paramètres des topologies déjà présentes dans le tableau 300.

De façon similaire à l'étape 202, l'étape d'optimisation fine 203 débute par la récupération de la liste des solutions explorables qui correspond à la liste des réseaux stockés dans le tableau 300 à la colonne d'indice n et à la ligne m=0 (toutes les branches ont été optimisées) et qui satisfont le critère d'explorabilité précédemment décrit.

A la différence de l'étape d'optimisation 202, lors de cette étape 203 on s'autorise à modifier directement tous les paramètres, à savoir les longueurs des branches et les impédances des charges en fin de branche pour un même réseau. Ceci permet d'améliorer les premiers paramètres trouvés (pour des valeurs de m élevées) en prenant en compte ceux trouvés ensuite (pour des valeurs de m faibles).

Une fois qu'on a sélectionné les réseaux qui seront affinés, l'étape d'optimisation fine 203 est réalisée au moyen d'un algorithme récursif qui prend en argument un paramètre à optimiser (longueur ou impédance).

Initialement, l'algorithme est exécuté sur la première branche du réseau (la plus en amont).

L'algorithme détermine si le paramètre donné en argument est un câble ou bien une impédance.

Si il s'agit d'un câble, dont la longueur est L, on fait varier sa longueur entre $max(0, L - L_{coarse})$ et $min(L_{max}, L + L_{coarse})$ par pas de $L_{fine}$, où $L_{coarse}$ et $L_{fine}$ sont des paramètres prédéfinis.

S'il s'agit d'une impédance dont la valeur correspond à un coefficient de réflexion $\Gamma$, on fait varier la charge pour avoir un coefficient de réflexion entre $max(-1 + \Gamma_{coarse}, \Gamma - \Gamma_{coarse})$ et $min(+1 - \Gamma_{coarse}, \Gamma + \Gamma_{coarse})$ par pas de $\Gamma_{fine}$ où $\Gamma_{coarse}$ et $\Gamma_{fine}$ sont des paramètres prédéfinis.

On calcule la valeur de la fonction de coût pour chaque nouvelle configuration et on conserve celle qui minimise la fonction de coût.

Ensuite, on appelle récursivement l'algorithme d'optimisation sur les autres branches du réseau qui sont connectées en bout de ligne de la branche déjà traitée (s'il y en a) ; en d'autres mots, on progresse en aval du réseau.

L'étape d'optimisation fine 203 permet d'affiner les valeurs des paramètres de longueur et d'impédance déterminés à l'étape 202 sur une grille de recherche plus fine. En effet, dans l'étape 202, la recherche est faite sur une grille dont le pas est donné par les valeurs $L_{coarse}$ et $\Gamma_{coarse}$ tandis qu'à l'étape 203, la recherche est faite sur une grille dont le pas est donné par les valeurs $L_{fine}$ et $\Gamma_{fine}$ qui sont choisies inférieures aux valeurs $L_{coarse}$ et $\Gamma_{coarse}$.

A l'étape 204 de la méthode, on applique cette fois des transformations, aux modèles de topologie mémorisés pour remplacer des charges optimisées par des jonctions. En effet, en analysant un réflectogramme, il n'est pas possible à première vue de distinguer une réflexion du signal sur une charge en fin de câble d'une réflexion sur une jonction.

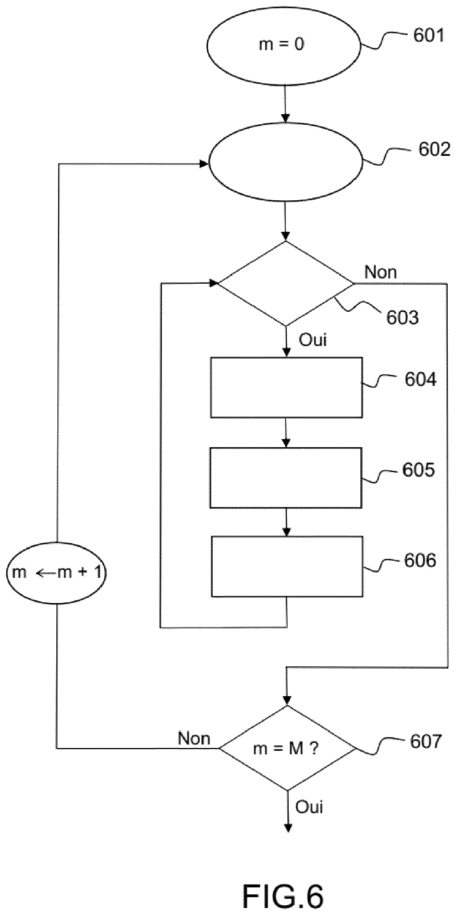

La figure 6 détaille, sur un organigramme, les étapes de mise en oeuvre d'un exemple d'algorithme exécuté à l'étape 204.

Les étapes d'initialisation 601 et 602 sont similaires aux étapes d'initialisation correspondantes 501 et 502 de la méthode d'optimisation décrite à la figure 5.

Une différence est que la boucle extérieure sur l'indice m est initialisée à m= 0 et est incrémenté de 1 à chaque nouvelle itération. Autrement dit, contrairement à l'étape d'optimisation 202, pour cette étape de modification 204 on traite chaque colonne du tableau 300 en démarrant par m=0 et en progressant dans la colonne de m= 0 vers les valeurs de m plus élevées.

L'étape 602 consiste à retenir les solutions qui respectent un critère d'explorabilité spécifique à l'étape 204, c'est-à-dire qui met en oeuvre des seuils d'acceptation différents de ceux utilisés à l'étape 202.

Pour l'étape 204 de transformation, le seuil d'acceptation $\theta_t^S$ est préférentiellement choisi supérieur à 1 et par exemple compris entre 1 et 2.

Par ailleurs, sa valeur est croissante en fonction des itérations sur t. Par exemple $\theta_1^S = 1.01$ et $\theta_T^S = 1.2$ et la valeur du seuil croit entre ces deux bornes en fonction de la valeur de l'itération t.

La valeur du seuil d'acceptation pour l'opération d'optimisation est supérieure à 1 car il est difficile de réduire le cout d'une solution lorsqu'on remplace une charge optimisée par une jonction rigide. Lors de l'étape 204 qui vise à ajouter des jonctions rigides vers plusieurs nouvelles branches à la place d'une charge déjà optimisé, on s'autorise donc à dégrader temporairement le cout des nouvelles solutions générées.

A l'étape 603, on vérifie que la liste des solutions explorables L n'est pas vide. Si elle est vide on passe à l'itération suivante sur m (m=m+1), sinon on traite les solutions de la liste L dans l'ordre séquentiel à l'étape 604.

A l'étape 605, pour chaque solution retenue, on détermine quelles charges dans le réseau v sont susceptibles de correspondre éventuellement à une jonction. Un critère possible est de retenir toutes les charges dont l'impédance

$Z_j$ est strictement inférieure à l'impédance $Z_0$ du câble, autrement dit dont le coefficient de réflexion est négatif.

Un autre critère consiste à retenir toutes les charges qui ont été optimisées lors des étapes 202,203 précédentes.

Ensuite, à l'étape 606, on génère plusieurs nouveaux modèles de topologie de réseau en remplaçant chaque charge identifiée à l'étape 605 par une jonction vers un nombre p de nouvelles branches non optimisées.

Le nombre p varie de 2 au minimum parmi P et N-n. P est le nombre de branches maximal après une jonction qui est un paramètre prédéterminé.

Le nombre de branches doit aussi être inférieur à N-n car le nouveau réseau généré après l'étape 606 sera constitué de n+p branches, or le nombre de total de branches d'un réseau doit être au plus égal à N.

Pour chaque valeur de p, on remplace la charge optimisée par une jonction à p branches non optimisées qui sont simulées comme des branches terminées par une charge adaptée à l'impédance des câbles. Ces nouvelles branches n'ont donc pas d'impact sur le réflectogramme simulé. On calcule ensuite la valeur de la fonction de cout pour chaque nouveau réseau généré par simulation du réflectogramme et comparaison avec le réflectogramme initial mesuré puis on ne conserve comme solutions candidates que celles qui satisfont le critère C(v) ≤ $\theta_T^S \times C(v')$ où v' est l'état précédent de la solution. $\theta_T^S$ est la valeur maximale du seuil d'acceptation au delà duquel on considère qu'il n'est pas nécessaire de sauvegarder la solution testée.

Les nouvelles solutions générées à l'étape 606 sont sauvegardées dans le tableau 300 dans la colonne d'indice n+p et pour des valeurs de m supérieures ou égales à 2. Ces nouvelles solutions seront ensuite optimisées lors d'une itération prochaine sur l'indice n via l'étape d'optimisation 202.

L'étape 204 de la méthode se termine lorsque toutes les solutions stockées dans une colonne du tableau 300 ont été traitées (m=M, étape 607).

On revient à la figure 2, la méthode d'optimisation comporte encore une autre étape optionnelle 205 qui vise à générer de nouvelles solutions en ajoutant une jonction le long d'une branche déjà optimisée.

A nouveau, de façon similaire aux autres opérations, on récupère la liste des solutions candidates, qui correspondent ici aux réseaux à n cables et aucune branche adaptée m = 0.

Pour chaque solution considérée, on parcourt chacune des branches (de longueur *L*) et, pour toutes les positions le long de cette branche (entre 0 et *L* par incréments linéaires de *L$_{coarse}$*) on essaye de rajouter une jonction (vers une branche qui se termine par une charge adaptée) le long de cette branche (pour toutes les longueurs entre 0 et *L*) par pas de *L$_{coarse}$*. Ensuite on modifie les charges en aval et en amont de cette jonction pour tenir compte de l'influence de cette nouvelle jonction.

Modifier les charges en aval se déroule comme suit : pour chaque charge qui se situe en aval du réseau par rapport à la nouvelle jonction, si on dénote son coefficient de réflexion par Γ, on la remplace par une charge telle que son nouveau coefficient de réflexion a une valeur supérieure, par exemple égale à $\frac{9}{4}\Gamma$, ce qui permet de compenser la perte d'amplitude par un facteur 4/9 suite à l'ajout d'une jonction de long du chemin vers cette charge.

On calcule ensuite la fonction de cout de ce nouveau réseau v. Si le coût est tel que $C(v) \leq \theta_T^s \times C(v')$ (où v' désigne le réseau avant le rajout d'un départ de câble), on l'ajoute à l'ensemble des solutions selon la procédure déjà décrite précédemment.

Les étapes 202 à 205 sont itérées pour toutes les valeurs de n jusqu'à N ce qui revient à remplir progressivement le tableau 300 de la colonne n=1 jusqu'à n= N.

Ensuite on passe à l'étape 207 qui consiste à vérifier, si parmi l'ensemble des solutions sauvegardées dans le tableau 300, au moins une solution satisfait un critère d'arrêt de la méthode. Ce critère d'arrêt consiste par exemple à comparer la fonction de cout C(v) de chaque solution à un seuil d'arrêt dont la valeur est proche de 0.

Si au moins une solution vérifie le critère d'arrêt de l'étape 207, on conserve celle qui minimise la fonction de cout. Il est aussi possible de récupérer plusieurs solutions en sortie de l'algorithme si leurs fonctions de cout sont très proches. Dans une telle situation, un indicateur d'une possible ambiguïté entre ces solutions peut être fourni. Si le critère d'arrêt n'est pas vérifié, on passe à une nouvelle itération sur la variable t, en relâchant les contraintes sur les seuils d'acceptation $\theta_t^S$ et $\theta_t^O$, c'est-à-dire en les augmentant de manière à explorer un plus grand nombre de solutions lors des étapes d'optimisation et de génération de nouveaux réseaux.

Si à l'issue de toutes les itérations sur la variable t, aucune solution ne satisfait le critère d'arrêt 207, on retient la solution qui minimise la fonction de cout.

Dans un mode de réalisation particulier de l'invention, lors de l'étape de sauvegarde d'un nouveau réseau dans le tableau 300, on détermine au préalable si ce nouveau réseau n'est pas identique ou quasi identique à un modèle déjà généré et présent dans le tableau 300.

Deux modèles de réseau v et v' sont considérés quasi identiques si :

- Ils ont la même structure, c'est-à-dire le même nombre de branches et les mêmes jonctions,

- Si pour chaque branche de v et son équivalent pour v', de longueurs respectives L et L', ces longueurs sont proches soit $|L - L'| \leq L_{tol}$ avec $L_{tol}$ un paramètre prédéfini,

- Si pour chaque charge de v et son équivalent pour v', les valeurs des impédances ou des coefficients de réflexions sont proches, c'est-à-dire si $|\Gamma - \Gamma| \leq \Gamma_{tol}$ avec $\Gamma_{tol}$ un paramètre prédéfini.

Par ailleurs, comme l'ordre des branches dans les jonctions de v et v' est arbitraire, on peut avoir deux réseaux identiques mais dont la représentation est différente si on permute les branches à la sortie des jonctions. On effectue donc ce test pour toutes les permutations des branches en sortie de toutes les jonctions de v'.

Pour éviter une explosion combinatoire et avoir une implémentation efficace de ces multiples comparaisons, deux variantes de réalisation sont possibles.

Tout d'abord, la détection des réseaux identiques est réalisée de façon récursive en démarrant en amont des réseaux et en s'arrêtant dès qu'on est certain qu'aucune permutation ne donne un résultat concluant.

Pour éviter de nombreuses comparaisons entre réseaux identiques, on stocke les résultats des différentes comparaisons, et ceux-ci sont automatiquement récupérés lorsqu'on doit ré-effectuer le même calcul.

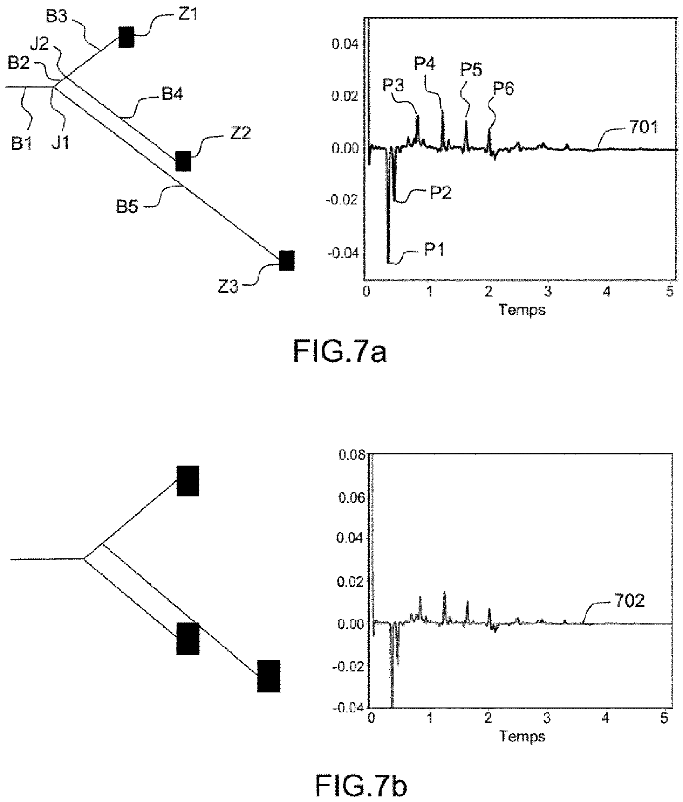

La figure 7a illustre un exemple de résultat obtenu par l'invention pour un réseau de câbles composé de cinq branches B1 ,B2,B3,B4,B5 et trois charges Z1,Z2,Z3. Le réflectogramme 701 mesuré pour ce réseau est représenté sur la droite de la figure où on a identifié plusieurs pics P1 ,P2,P3,P4,P5,P6 correspondant à différentes singularités du réseau.

Précisément, le premier pic P1 correspond à la réflexion du signal sur la première jonction J1 entre les branches B1 ,B2 et B5.

Le deuxième pic P2 correspond à la réflexion du signal sur la seconde jonction J2 entre les branches B2, B3 et B4.

Le troisième pic P3 correspond à la réflexion du signal sur la charge Z1 à l'extrémité de la branche B3.

Le quatrième pic P4 correspond à la réflexion du signal sur la charge Z2 à l'extrémité de la branche B4.

Le cinquième pic P5 correspond à une combinaison des réflexions sur les charges Z1 et Z2 correspond à un trajet du signal vers la charge Z1 puis vers la charge Z2 (et inversement).

Le sixième pic P6 correspond à la réflexion du signal sur la charge Z3 à l'extrémité de la branche B5.

La figure 7b représente le réflectogramme 702 obtenu en appliquant une méthode itérative selon l'art antérieur de type algorithme glouton. Le réflectogramme 702 est représenté en superposition au réflectogramme mesuré 701. La topologie de réseau reconstruite via cet algorithme est représentée sur la gauche de la figure.

On voit que la branche B5 n'est pas correctement reconstruite car l'algorithme converge vers un optimum local dès le cinquième pic P5 sans prendre en compte le sixième pic P6 qui correspond en réalité à la branche B5.

Dans le cas d'un algorithme génétique, celui-ci est capable de retrouver la topologie correcte sur cet exemple mais seulement 1 fois sur 10.

A l'inverse, la méthode selon l'invention permet de retrouver exactement la bonne topologie de réseau pour cet exemple et de façon systématique avec un temps de convergence supérieur à celui de l'approche itérative mais qui permet de restituer un résultat fiable du fait d'une exploration plus large des solutions possibles.

Le procédé selon l'invention peut être mis en oeuvre en tant que programme d'ordinateur, le procédé étant appliqué à une mesure de réflectométrie préalablement acquise à l'aide d'un dispositif de réflectométrie usuel. L'invention peut être mise en oeuvre en tant que programme d'ordinateur comportant des instructions pour son exécution. Le programme d'ordinateur peut être enregistré sur un support d'enregistrement lisible par un processeur. La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués (*"Cloud computing"*), éventuellement selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

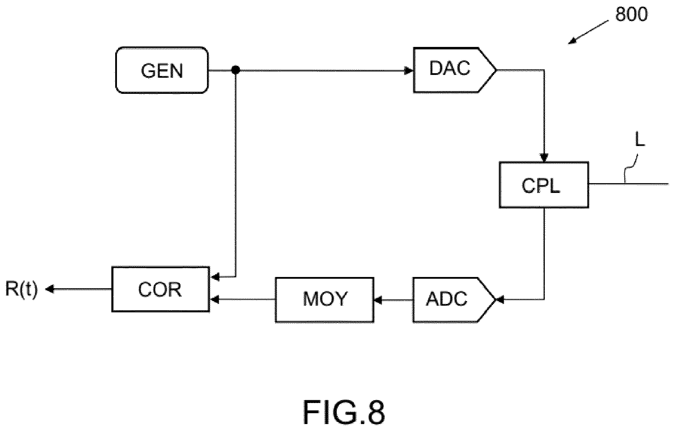

Alternativement, l'invention peut aussi être mise en oeuvre dans un dispositif embarqué tel que décrit à la figure 8 comprenant en outre un calculateur configuré pour exécuter le procédé selon l'invention afin de fournir, à partir d'un réflectogramme mesuré, une ou plusieurs topologies probables du réseau sous test. Le dispositif peut comporter également un moyen d'affichage des résultats du procédé sous forme de graphe ou sous forme numérique.

La figure 8 représente à cet effet un schéma d'un système 800 de réflectométrie connecté à une ligne de transmission L (représentée comme une simple ligne sur la figure 8 mais qui peut être un réseau de câbles plus complexe), telle qu'un câble, et configuré pour réaliser une mesure de réflectométrie temporelle. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur directionnel CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur les singularités du réseau de câble. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Une corrélation COR peut être effectuée (selon le type de signal utilisé) entre le signal numérique mesuré et une copie du signal numérique généré avant injection afin de produire un réflectogramme temporel R(t) correspondant à l'inter-corrélation entre les deux signaux.

**Revendications**

1. Procédé itératif, mis en oeuvre par ordinateur, de reconstruction de la topologie d'un réseau de câbles, le procédé comprenant les étapes de :

   - Obtenir (200) un réflectogramme temporel mesuré à partir d'un signal préalablement injecté dans le réseau de câbles,
   - Rechercher un modèle de topologie de réseau de câbles correspondant audit réflectogramme mesuré en exécutant à partir d'un modèle initial de topologie, plusieurs itérations d'au moins deux étapes successives de transformation d'un modèle de topologie :

      i. Une première étape d'optimisation (202) des branches non optimisées d'au moins un modèle de topologie sauvegardé à l'itération précédente, l'optimisation portant au moins sur la longueur des branches et/ou l'impédance des charges en fin de branches,
      ii. Une seconde étape de génération (204) de nouveaux modèles de topologie en remplaçant une charge en fin de branche d'un modèle de topologie sauvegardé après la première étape d'optimisation (202), par une jonction vers plusieurs branches non optimisées,

   - Chaque étape de transformation (202,204) impliquant le calcul d'une fonction de cout représentative d'une erreur entre le réflectogramme temporel mesuré et un réflectogramme simulé à partir d'un modèle de topologie,
   - A l'issue de chaque étape de transformation (202,204), sauvegarder les modèles de topologie pour lesquels le rapport entre la fonction de cout calculée pour le modèle obtenu après transformation et celle calculée pour le modèle avant transformation, appelée valeur d'amélioration relative, est inférieure à une valeur maximale d'un seuil prédéterminé.

2. Procédé de reconstruction de la topologie d'un réseau de câbles selon la revendication 1 dans lequel chacune des deux étapes de transformation (202,204) comprend la sélection, parmi les modèles sauvegardés, de ceux pour lesquels la valeur d'amélioration relative est inférieure à une valeur courante du seuil prédéterminé.

3. Procédé de reconstruction de la topologie d'un réseau de câbles selon l'une quelconque des revendications précédentes dans lequel la première étape d'optimisation (202) comprend, pour chaque branche d'un modèle de topologie à optimiser, le calcul de plusieurs valeurs d'amélioration relative pour différentes hypothèses de longueur de branche et/ou différentes hypothèses de valeurs d'impédance de charges.

4. Procédé de reconstruction de la topologie d'un réseau de câbles selon l'une quelconque des revendications précédentes dans lequel la seconde étape de génération (204) de nouveaux modèles de topologie comprend, pour chaque nouveau modèle de topologie optimisé par la première étape d'optimisation, le calcul de plusieurs valeurs d'amélioration relative pour différentes valeurs de nombre de branches non optimisées connectées à une jonction modélisée en remplacement d'une charge en fin de branche optimisée.

5. Procédé de reconstruction de la topologie d'un réseau de câbles selon l'une quelconque des revendications précédentes dans lequel le seuil prédéterminé a une valeur différente pour chacune des deux étapes de transformation (202,204).

6. Procédé de reconstruction de la topologie d'un réseau de câbles selon la revendication 5 dans lequel la valeur du seuil prédéterminé pour la première étape d'optimisation (202) est inférieure à 1, par exemple comprise entre 0.5 et 0.99.

7. Procédé de reconstruction de la topologie d'un réseau de câbles selon l'une quelconque des revendications 5 ou 6 dans lequel la valeur du seuil prédéterminé pour la seconde étape de génération (204) est supérieure à 1, par exemple comprise entre 1.01 et 1.2.

8. Procédé de reconstruction de la topologie d'un réseau de câbles selon l'une quelconque des revendications précédentes comprenant, lorsque le nombre de branches n d'un modèle de topologie généré par la seconde étape de génération atteint une valeur maximale prédéfinie N, une nouvelle itération de l'ensemble des étapes du procédé en augmentant la valeur courante du seuil prédéterminé pour au moins l'une des étapes de transformation.

9. Procédé de reconstruction de la topologie d'un réseau de câbles selon l'une quelconque des revendications précédentes comprenant en outre une étape supplémentaire (203) d'optimisation des modèles de topologie optimisés par la première étape d'optimisation (202) en recherchant, pour chaque paramètre à optimiser, sur un intervalle prédéfini centré sur la valeur dudit paramètre, une valeur modifiée qui minimise la fonction de cout sur l'intervalle.

10. Procédé de reconstruction de la topologie d'un réseau de câbles selon l'une quelconque des revendications précédentes comprenant en outre une troisième étape de transformation (205) d'un modèle de topologie consistant à ajouter à une branche d'un modèle de topologie sauvegardé à l'étape précédente une nouvelle jonction en une position variable et, pour chaque nouveau modèle de topologie optimisé lors des étapes précédentes, le calcul de plusieurs valeurs d'amélioration relative pour différentes valeurs de ladite position.

11. Procédé de reconstruction de la topologie d'un réseau de câbles selon l'une quelconque des revendications précédentes comprenant une étape d'arrêt (207) du procédé lorsque la fonction de cout calculée pour au moins un modèle de topologie est inférieure à un seuil d'arrêt prédéterminé.

12. Procédé de reconstruction de la topologie d'un réseau de câbles selon l'une des revendications précédentes comprenant une étape d'affichage de la topologie reconstruite du réseau de câbles sur un dispositif d'affichage.

13. Procédé de reconstruction de la topologie d'un réseau de câbles selon l'une des revendications précédentes comprenant une étape préalable d'injection du signal dans le réseau de câbles.

14. Programme d'ordinateur comportant des instructions pour l'exécution du procédé de reconstruction de la topologie d'un réseau de câbles selon l'une quelconque des revendications 1 à 13, lorsque le programme est exécuté par un processeur.

15. Support d'enregistrement lisible par un processeur sur lequel est enregistré un programme comportant des instructions pour l'exécution du procédé de reconstruction de la topologie d'un réseau de câbles selon l'une quelconque des revendications 1 à 13, lorsque le programme est exécuté par un processeur.

$v^* \in V$

FIG.1

$y$

Initialisation globale t =1 — 200

Initialisation interne n =1 — 201

Optimisation — 202

Optimisation fine — 203

Transformation — 204

Transformation — 205

$n \leftarrow N + 1$

$t \leftarrow t + 1$

Non — n = N ? — 206

Oui

Non — Critère d'arrêt ? — 207

Oui

FIG.2

FIG.3

FIG.4a

FIG.4b

FIG.5

FIG.6

FIG.7a

FIG.7b

FIG.8

Europäisches
Patentamt

European
Patent Office

Office européen
des brevets

# RAPPORT DE RECHERCHE EUROPEENNE

Numéro de la demande

EP 24 16 6470

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2006/182269 A1 (LO CHET [US] ET AL) 17 août 2006 (2006-08-17) * alinéas [0026], [0037], [0043]; revendications 22-24 * ----- | 1-3, 12-15 | INV. H04B3/46 G01R31/11 H04L43/00 |

DOMAINES TECHNIQUES RECHERCHES (IPC)

H04B
G01R
H04L

Le présent rapport a été établi pour toutes les revendications

| Lieu de la recherche | Date d'achèvement de la recherche | Examinateur |
|---|---|---|
| La Haye | 23 mai 2024 | De Iulis, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 16 6470

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-05-2024

| Document brevet cité au rapport de recherche | Date de publication | Membre(s) de la famille de brevet(s) | Date de publication |
|---|---|---|---|
| US 2006182269 A1 | 17-08-2006 | AUCUN | |

Pour tout renseignement concernant cette annexe : voir Journal Officiel de l'Office européen des brevets, No.12/82

**EP 4 439 991 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2019030246 A, Demandeur
- WO 2019034497 A, Demandeur